(19) Europäisches Patentamt
European Patent Office
Office européen des brevets

(11) **EP 2 546 662 A1**

(12) **EUROPEAN PATENT APPLICATION**

(43) Date of publication:
**16.01.2013 Bulletin 2013/03**

(51) Int Cl.:
**G01R 23/15** *(2006.01)*    **G01R 23/10** *(2006.01)*

(21) Application number: **11182857.0**

(22) Date of filing: **27.09.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **15.07.2011 TW 100125199**

(71) Applicants:
• **Askey Technology (Jiangsu) Ltd.**
  **Economic-Technological Development Area**
  **Wujiang Jiangsu (CN)**
• **Askey Computer Corp.**
  **New Taipei City 235 (TW)**

(72) Inventors:
• **Chou, Ming-Hung**
  **110 Taipei City (TW)**
• **Wang, Nai-Jian**
  **106 Taipei City (TW)**
• **Hsieh, Ching-Feng**
  **108 Taipei City (TW)**

(74) Representative: **Bonvicini, Davide et al**
  **Perani & Partners**
  **Patent**
  **Piazza San Babila, 5**
  **20122 Milano (MI) (IT)**

(54) **Frequency counter**

(57)    A frequency counter obtains a cycle number (Ni) of a clock of a target signal by a reference signal (FB) and a clock mask (mk_FI) synchronous with the target signal, calculates a frequency (FI) of the target signal based on the cycle number, corrects the frequency according to a plurality of phase shift signals (FB-pi) generated based on the reference signal, and minimizes an error of the calculated frequency by increasing the quantity of the phase shift signals, so as to enhance the accuracy of the calculated frequency of the target signal, speed up measurement, and reduce required circuit areas.

FIG. 1

EP 2 546 662 A1

**Description**

FIELD OF THE INVENTION

The present invention relates to frequency counters, and more particularly, to a frequency counter for obtaining a frequency rapidly and precisely.

BACKGROUND OF THE INVENTION

Normally, the frequency of a clock signal is measured by a frequency counter. The measurement involves counting the number of cycles of the clock signal during a gate time period set by the frequency counter and then obtaining the frequency of the clock signal as a result of dividing the count by the gate time period.
Nonetheless, the number of cycles of a clock signal during a gate time period is seldom an integer, and thus the method is likely to cause an error at the beginning and the end of the gate time period - underestimating or overestimating by a half cycle, for example. In view of this, to measure frequency, it is usually necessary to maximize the gate time period in order to handle as many cycles as possible and thereby reduce errors. However, the aforesaid solution is performed at the cost of a great increase in the testing time and with the tendency to decrease resolution due to a short gate time period.

SUMMARY OF THE INVENTION

It is an objective of the present invention to enhance the speed and accuracy of frequency measurement.
Another objective of the present invention is to provide a high-speed, high-precision frequency counter that requires little circuit-occupied area.
In order to achieve the above and other objectives, the present invention provides a frequency counter for measuring a frequency of a target signal when enabled by a gate signal. The frequency counter comprises a signal input end, a reference signal generating module, a programmable gate array, and a control unit. The signal input end receives the target signal. The reference signal generating module outputs a reference signal of a frequency Fb higher than the target signal. The programmable gate array is adapted for receiving a gate frequency to generate the gate signal, receiving the target signal from the signal input end to form a target signal clock mask, counting a cycle number Ni of the target signal within the target signal clock mask, receiving the reference signal from the reference signal generating module to form a reference signal clock mask, counting a cycle number Nb of the reference signal within the reference signal clock mask, generating M phase shift signals based on the reference signal, the phase shift signals being of a same frequency and spaced apart from each other by a fixed phase, wherein M≧2, counting a number Nd1 of instances of occurrence of a triggering state to the phase shift signals during a time period from a beginning point in time of the target signal clock mask to a beginning point in time of the reference signal clock mask, counting a number Nd2 of instances of occurrence of the same triggering state to the phase shift signals during a time period from an ending point in time of the target signal clock mask to an ending point in time of the reference signal clock mask, and outputting the values Nb, Ni, Nd1, and Nd2. The control unit is connected to the programmable gate array and the reference signal generating module for receiving the values Nb, Ni, Nd1, and Nd2 and performing computation based on $Fi = \{Ni/[Nb + (Nd/M)]\} \times Fb$ to obtain a frequency Fi of the target signal, wherein Fb > Fi, and Nd = (Nd1 - Nd2).
The programmable gate array comprises a gate determining module, a clock mask generating module, a target signal cycle number counting module, a delay module, a reference signal cycle number counting module, a digital clock manager module, and an error counting module. The programmable gate array is adapted for receiving the gate frequency and receiving the target signal from the signal input end to generate the gate signal. The clock mask generating module is connected to the signal input end for receiving the target signal. The clock mask generating module sets a first beginning point in time of a first triggering state synchronous with the target signal based on the enabling gate signal, and sets a first ending point in time of the first triggering state synchronous with the target signal based on the disabling gate signal, so as to form the target signal clock mask. The target signal cycle number counting module is connected to the signal input end and the clock mask generating module for receiving the target signal and the target signal clock mask so as to count a cycle number Fi of the target signal within the target signal clock mask. The delay module is connected to the reference signal generating module and the clock mask generating module for receiving the reference signal and the target signal clock mask. The delay module sets a second beginning point in time of a second triggering state synchronous with the reference signal based on the first beginning point in time and sets a second ending point in time of the second triggering state synchronous with the reference signal based on the first ending point in time so as to form the reference signal clock mask. The reference signal cycle number counting module is connected to the reference signal generating module and the delay module for receiving the reference signal and the reference signal clock mask and adapted to count a cycle number Fb of the reference signal within the reference signal clock mask. The digital clock manager module is connected to the reference signal generating module for receiving the reference signal and generating the phase shift signals based on the reference signal. The error counting module is connected to the clock mask generating module, the delay module, and the digital clock manager module for receiving the target signal clock mask, the reference signal clock mask, and the phase shift signals. The error counting module counts a number Nd1 of instances of occurrence of a third triggering state to the phase shift signals during a time period from a beginning point in time of the target signal clock mask to a beginning point in time of the reference signal clock mask and counts a number Nd2 of instances of occurrence of the third triggering state to the phase shift signals during a time period from an ending point in time of the target signal clock mask to an ending point in time of the reference signal clock mask.

In an embodiment of the present invention, with the delay module, the delay clock mask mk_dly is calculated by delaying the reference signal clock mask mk_FB by a predetermined phase based on the reference signal FB, such that the control unit begins to perform computation upon the termination of the delay clock mask mk_dly. The delay module further comprises a first delay unit and a second delay unit. The first delay unit is connected to the reference signal generating module and the clock mask generating module for receiving the reference signal FB and the target signal clock mask mk_FI and generating the reference signal clock mask mk_FB. The second delay unit is connected to the reference signal generating module and the first delay unit for receiving the reference signal FB and the reference signal clock mask mk_FB. The second delay unit sets a third beginning point in time of the second triggering state synchronous with the reference signal FB based on the second beginning point in time and sets a third ending point in time of the second triggering state synchronous with the reference signal FB based on the second ending point in time, wherein the delay clock mask mk_dly is defined between the third beginning point in time and the third ending point in time.

In an embodiment of the present invention, the reference signal generating module comprises a fundamental frequency generating unit and a frequency multiplying unit. The fundamental frequency generating unit generates a fundamental frequency signal. The frequency multiplying unit is connected to the fundamental frequency generating unit for turning the fundamental frequency signal into the reference signal by frequency multiplication.

In an embodiment of the present invention, the control unit replaces the value Fb with a default value.

In an embodiment of the present invention, the first triggering state is one of a rising edge triggering state and a falling edge triggering state, the second triggering state is one of a rising edge triggering state and a falling edge triggering state, and the third triggering state is one of a rising edge triggering state and a falling edge triggering state.

In an embodiment of the present invention, the reference signal cycle number counting module is connected to the reference signal generating module and the clock mask generating module for receiving the reference signal and the target signal clock mask and counting a cycle number Fb of the reference signal within the target signal clock mask.

In an embodiment of the present invention, the programmable gate array treats the reference signal as the gate frequency.

In conclusion, with quick and precise multiphase processing, the frequency counter of the present invention eliminates frequency measurement errors, multiplies the accuracy of measurement in accordance with the quantity of generated phase shift signals, effectuates the precise control of frequency measurement based on synchronous triggering, and reduces the area occupied by a circuit. Hence, the frequency counter of the present invention excels a conventional frequency counter.

BRIEF DESCRIPTION OF THE DRAWINGS

Objectives, features, and advantages of the present invention are hereunder illustrated with specific embodiments in conjunction with the accompanying drawings, in which:

FIG 1 is a timing diagram of operation of frequency measurement according to an embodiment of the present invention;
FIG 2 is a function block diagram of a frequency counter according to an embodiment of the present invention;
FIG 3 is a function block diagram of a programmable gate array according to an embodiment of the present invention; and
FIG 4 is a function block diagram of a delay module according to an embodiment of the present invention.

DETAILED DESCRIPTION OF THE PREFERRED EMBODIMENTS

The present invention provides a frequency counter based on a frequency measurement method. After gaining insight into the timing and operation relationships and the counting rules of the frequency measurement method, persons skilled in the art are able to accomplish readily the subsequent generation of various signals the logical computation related components required for timing calculation.

The frequency measurement method proposed according to an embodiment of the present invention simplifies the components required for the frequency counter and enables the frequency measurement process to be carried out rapidly and precisely.

The frequency measurement method for use with the frequency counter of the present invention has to employ a reference signal of a frequency higher than that of a target signal. For example, by making reference to a frequency range to be measured, a user selects an appropriate signal generating module for generating a reference signal of a frequency that falls outside the frequency range to be measured.

The steps of a frequency measurement method for use with the frequency counter of the present invention are described in specific embodiments thereof and are, unless otherwise specified, interchangeable in terms of sequence. Furthermore, the concept of "connection" used in the description of specific embodiments of a frequency measurement system for measuring distance according to the present invention is not limited to direct connection; instead, connection can also be effectuated by an intervening element. Also, a "first triggering state" and a "second triggering state" used in the description of the method and system for measuring frequency of the present invention comprise one of a rising edge triggering state and a falling edge triggering state. The first triggering state, the second triggering state, and the third triggering state are not mutually exclusive; hence, the first triggering state, the second triggering state, and the third triggering state are rising edge triggering states concurrently, falling edge triggering states concurrently, or any other possible combination thereof.

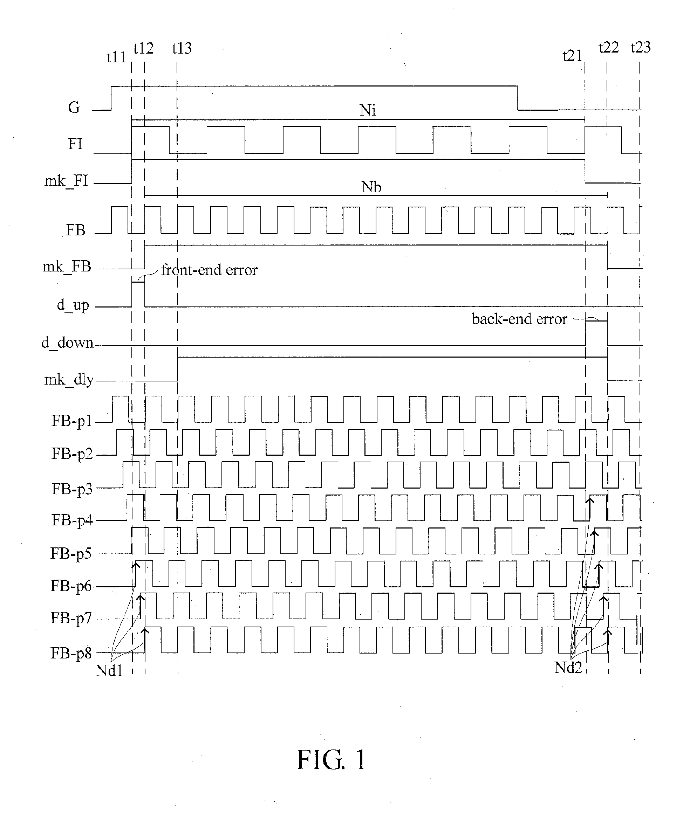

Referring to FIG 1, there is shown is a timing diagram of operation of frequency measurement according to an embodiment of the present invention. As shown in FIG 1, this embodiment is exemplified by eight phase shift signals, that is, M=8. Persons skilled in the art should be able to understand that, given at least two phase shift signals, the frequency counter of the present invention is effective in eliminating any errors of measurement and thereby enhancing the accuracy of measurement.

In an embodiment of the present invention, the frequency measurement method entails measuring a frequency of a target signal FI when enabled by a gate signal G Measuring the target signal FI involves counting frequency preliminarily and eliminating an error.

As shown in FIG 1, the reference signal FB is provided prior to inputting the gate signal G, and multilevel phase shift signals FB-p1~FB-p8 of the same frequency are generated based on the reference signal. The phase shift signals FB-p1-FB-p8 are spaced apart from each other by a fixed phase. Also, the provision of the reference signal FB occurs synchronously with the inputting of the gate signal G

Frequency measurement begins as soon as the gate signal G is input. The reference signal FB functions as a fundamental frequency for calculating the frequency of a target signal. The phase shift signals are generated from the reference signal FB. Normally, the phase shift signals are generated by means of a digital clock manager (DCM) module of a programmable gate array (FPGA). The digital clock manager module has therein at least one digital clock manager (DCM). In this embodiment, eight phase shift signals Fb-p1~Fb-p8 are processed by two digital clock managers, and the reference signal FB is decomposed by a digital clock manager to form four phase shift signals. However, persons skilled in the art should be able to understand that a user can still selectively shut down four of the phase shift decomposition processes even with just one digital clock manager. Hence, with only one digital clock manager, it is still possible to decompose the reference signal FB into two or three phase shift signals. Hence, users can select the quantity of required phase shift signals as needed and as appropriate for operation of a digital clock manager. Regarding the spacing of phase shift signals, a digital clock manager divides 360° into equal phase portions and distributes the equal phase portions among the phase shift signals. For example, the phase equals 360°/(M - 1), where M denotes the number of phase shift signals.

The inputting of the gate signal G is followed by the generation of a target signal clock mask mk_FI which begins at the first triggering state of the target signal FI and ends at another said first triggering state of the target signal FI. In this embodiment, the first triggering state is exemplified by a rising edge triggering state, that is, the target signal clock mask mk_FI is synchronous with the target signal FI. In the first rising edge triggering state of the target signal FI when enabled by the gate signal G, the target signal clock mask mk_FI is synchronously triggered to begin. The target signal clock mask mk_FI is triggered at a first beginning point in time t11. The target signal clock mask mk_FI maintains a high level state until the first rising edge triggering state occurs to the target signal FI when disabled by the gate signal G The target signal clock mask mk_FI ends at another said first triggering state of the target signal FI, that is, it ends at a first ending point in time t12.

In the embodiment illustrated with FIG 1, the target signal clock mask mk_FI ends at the seventh said first triggering state of the target signal FI after passing six cycles of the target signal FI; hence, the target signal cycle number counting module obtains the cycle number Ni of the target signal FI, that is, Ni = 6, where Ni = (the number of times the first triggering state occurs to the target signal FI) - 1. The cycle number Ni of the target signal FI is at least 1 and is preferably 2 or more. The gate signal G is appropriately selected according a predetermined measurable range of frequency. For example, if the maximum predetermined measurable range of frequency is 10 Hz, the time period covered by the gate signal G will last for at least 0.2 second or preferably at least 0.3 second.

Referring to FIG 1, during a measurement process, the reference signal FB does not necessarily synchronize with the target signal FI; hence, the time actually taken to measure the cycle number Nb of the reference signal FB does not fall within the range of the target signal clock mask mk_FI, thereby resulting in front-end errors and back-end errors.

Hence, in an embodiment of the present invention, front-end errors and back-end errors are eliminated by means of the phase shift signals. The reference signal clock mask mk_FB is generated to function as a basis of the definition of the time period of front-end errors and back-end errors.

The reference signal clock mask mk_FB is generated by delaying the target signal clock mask mk_FI. The reference signal clock mask mk_FB includes the cycle number Nb which is a multiple of an integer. After the target signal clock mask mk_FI is enabled (at the first beginning point in time t11), the reference signal clock mask mk_FB begins at the second triggering state of the reference signal FB and ends at another said second triggering state of the reference signal FB. In this embodiment, the second triggering state is exemplified by a rising edge triggering state; in other words, the reference signal clock mask mk_FB is synchronous with the reference signal FB. In the first rising edge triggering state of the reference signal FB after the first beginning point in time t11, the reference signal clock mask mk_FB is synchronously triggered to begin. The reference signal clock mask mk_FB is triggered at a second beginning point in time t21. The reference signal clock mask mk_FB maintains a high level state until the first rising edge triggering state occurs to the reference signal FB after the target signal clock mask mk_FI has been disabled. The reference signal clock mask mk_FB ends at another said second triggering state of the reference signal FB, that is, it ends at a second ending point in time t22.

The time period of shift between the target signal clock mask mk_FI and the reference signal clock mask mk_FB is an error generating time period, defining the front shift time period as a front error and the back shift time period as a back error. As a result, it is feasible to generate an upper differentiation signal d_up and a lower differentiation signal d_down. The number Nd1 of instances of occurrence of the third triggering state (i.e., a rising-edge or fall-edge triggering state) to the phase shift signals FB-p1~FB-p8 during a time period in which the upper differentiation signal d_up is enabled is counted. The number Nd2 of instances of occurrence of the third triggering state (i.e., a rising-edge or fall-edge triggering state) to the phase shift signals FB-p1~FB-p8 during a time period in which the lower differentiation signal d_down is enabled is counted.

Counting the third triggering states that occur to the phase shift signals FB-p1~FB-p8 means that a back-end error time period requires selecting the rising edge triggering state as the third triggering state when a front-end error time period requires selecting the rising edge triggering state as the third triggering state, or means that a back-end error time period requires selecting the falling edge triggering state as the third triggering state when a front-end error time period requires selecting the falling edge triggering state as the third triggering state. As shown in FIG 1, the rising edge triggering state is selected to function as the third triggering state, thereby setting Nd1 to 3 and Nd2 to 5.

In a subsequent calculation process, the number Nd1 is subtracted from the number Nd2 so as to obtain the cycle number to be actually calibrated and thereby eliminate front-end and back-end errors.

After the aforesaid values have been obtained, the frequency of the target signal FI can be calculated by equation (1):

$$Fi = \{Ni/[Nb + (Nd/M)]\} \times Fb \qquad (1)$$

Nd denotes a calibration value, where Nd = (Nd1 - Nd2). M denotes the number of the phase shift signals, where M 2, which means that at least two said phase shift signals are generated.

The embodiments of the present invention enhance the accuracy of frequency measurement. Basically, the frequency of the target signal FI is determined by equation (2):

$$(Ni/Fi) = (Nb/Fb) \qquad (2)$$

Fi denotes the frequency of the target signal FI. Fb denotes the frequency of the reference signal FB. Equation (2) can be rewritten as follows:

$$Fi \quad (Ni/Nb) \times Fb \qquad (3)$$

The condition for satisfying equation (3) lies in excellence of the reference signal FB over the target signal FI in frequency.

As revealed above, the frequency of the target signal FI will be inaccurate when calculated by equation (3), unless the front-end and back-end errors are calibrated. It is only after the front-end and back-end errors are eliminated that the range of the target signal clock mask mk_FI in an enable state is satisfactory. Hence, given the result of calculation of the calibrated value Nd, the extent of the front-end and back-end errors to be eliminated can be determined. In addition, equation (1) indicates that the accuracy of frequency measurement increases with the quantity of the phase shift signals by multiplication. The method disclosed in an embodiment of the present invention increases measurement accuracy eightfold when compared with a method that works without calibrating front-end errors and back-end errors.

Accordingly, the process flow of the frequency calibration method disclosed in an embodiment of the present invention is as follows:

providing the target signal FI, the gate signal G,the reference signal FB, and a plurality of phase shift signals FB-p1~FB-p8 based on the reference signal FB ;
providing the first beginning point in time t11 of the target signal clock mask mk_FI;

a) generating the second beginning point in time t21 of the reference signal clock mask mk_FB, the upper differentiation signal d_up, and the number Nd1 of instances of occurrence of the third triggering state within the time period of the upper differentiation signal d_up;
b) generating the first ending point in time t12 of the target signal clock mask mk_FI and the cycle number Ni of the target signal FI within the time period of the target signal clock mask mk_FI;
c) generating the second ending point in time t22 of the reference signal clock mask mk_FB, the cycle number Nb of the reference signal FB within the time period of the reference signal clock mask mk_FB, the lower differentiation signal d_down, and the number Nd2 of instances of occurrence of the third triggering state within the time period of the lower differentiation signal d_down;
d) performing computation by equation (1) to obtain the value Fi.

Furthermore, it is feasible to set the point in time of the termination of a session of the counting of a programmable gate array (FPGA) by a delay clock mask mk_dly such that, upon termination of the counting session, the values Nb, Ni, Nd1, and Nd2 are output for computation. The delay clock mask mk_dly is calculated by delaying the reference signal clock mask mk_FB by a predetermined phase based on the reference signal FB. Referring to FIG 1, the delay clock mask mk_dly is calculated by delaying the reference signal clock mask mk_FB by one cycle of the reference signal FB.

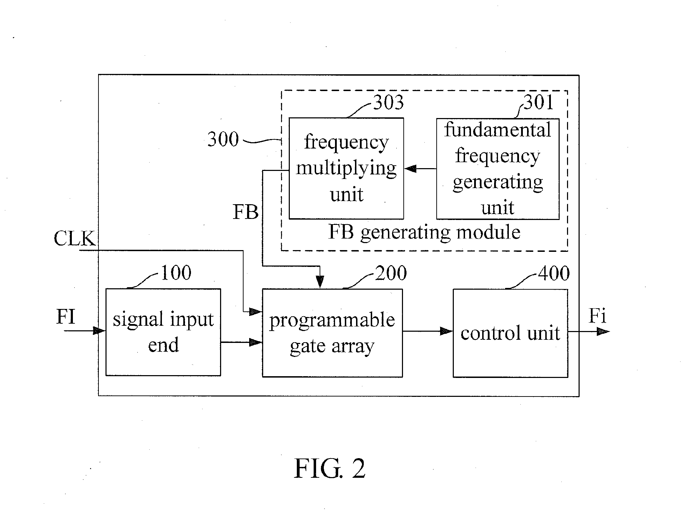

Referring to FIG 2, there is shown a function block diagram of the frequency counter according to an embodiment of the present invention. In an embodiment of the present invention, the frequency counter comprises a signal input end 100, an FB generating module 300 (i.e., a reference signal generating module), a programmable gate array 200, and a control unit 400.

The signal input end 100 receives the target signal FI. The FB generating module 300 outputs the reference signal FB. The frequency Nb of the reference signal FB falls outside the possible frequency range of the target signal FI. The programmable gate array 200 receives a gate frequency CLK (or, alternatively, receives the reference signal FB in another embodiment) and calculates various parameters. The control unit 400 is connected to the programmable gate array 200 for receiving the values Nb, Ni, Nd1, Nd2 and the known values Fb, M, and performing computation by equation (1) to obtain a frequency Fi of the target signal FI.

In an embodiment, the FB generating module 300 comprises a fundamental frequency generating unit 301 and a frequency multiplying unit 303. The fundamental frequency generating unit 301 generates a fundamental frequency signal. Normally, a low fundamental frequency is generated by a crystal oscillator to cut costs, and then the fundamental frequency is boosted by the frequency multiplying unit 303 connected to the fundamental frequency generating unit 301 for functioning as the reference signal FB. The fundamental frequency is usually increased to go beyond the possible frequency range of the frequency signal FI. Various frequency signals work with their respective frequencies of the reference signal FB. Of course, the higher the frequency of the reference signal FB is, the wider its application is.

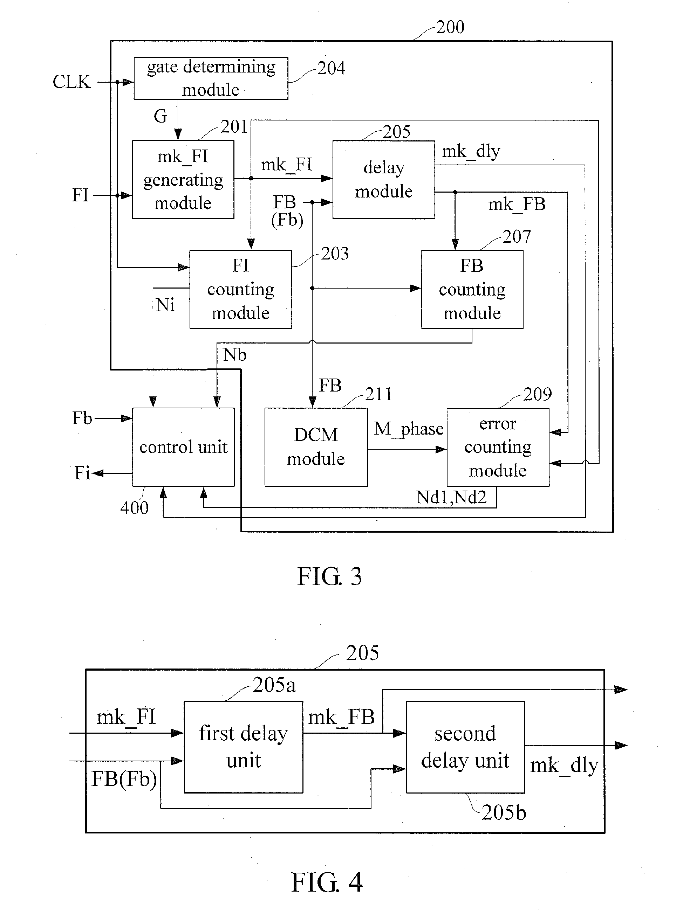

Referring to FIG 3, there is shown a function block diagram of a programmable gate array according to an embodiment of the present invention.

A gate determining module 204 receives the gate frequency CLK and receives the target signal FI from the signal input end 100 so as to generate the gate signal G The gate determining module 204 can even treat the reference signal FB as the gate frequency CLK, such that the gate signal G is synchronized with the reference signal FB. For example, the gate determining module 204 has the following functions: 1). dividing a frequency to thereby generate various gate signals of a period of 0.4sec, 0.2sec, or 0.1sec, for example; 2). determining an appropriate period of a gate signal, followed by sending the gate signal to any other module as needed; and 3). alternatively, enabling a user to determine the period of the gate signal.

An mk_FI generating module 201 (i.e., a clock mask generating module) is connected to the signal input end 100 and the gate determining module 204 for setting the first beginning point in time t11 of the first triggering state synchronous with the target signal FI based on the enabling gate signal G, and setting the first ending point in time t12 of the first triggering state synchronous with the target signal FI based on the disabling gate signal G,so as to form the target signal clock mask mk_FI.

An FI counting module 203 (i.e., a target signal cycle number counting module) is connected to the signal input end 100 and the mk_FI generating module 201 for receiving the target signal FI and the target signal clock mask mk_FI and counting the cycle number Fi of the target signal FI within the target signal clock mask mk_FI.

A delay module 205 is connected to the FB generating module 300 (i.e., a reference signal generating module) and the mk_FI generating module 201 for receiving the reference signal FB and the target signal clock mask mk_FI, setting the second beginning point in time t21 of the second triggering state synchronous with the reference signal FB based on the first beginning point in time t11, and setting the second ending point in time t22 of the second triggering state synchronous with the reference signal FB based on the first ending point in time t12, wherein the time period from t21 to t22 defines the reference signal clock mask mk_FB. The delay clock mask mk_dly is brought about by delaying the reference signal clock mask mk_FB by a predetermined phase based on the reference signal FB, such that the control unit 400 can perform computation upon the termination of the delay clock mask mk_dly. The delay clock mask mk_dly further ensures that the programmable gate array 200 has finished creating the values required for computation.

An FB counting module 207 (that is, a reference signal cycle number counting module) is connected to the FB generating module 300 and the delay module 205 for receiving the reference signal FB and the reference signal clock mask mk_FB and counting a cycle number Fb of the reference signal FB within the reference signal clock mask mk_FB. The FB counting module 207 can also be directly connected to the FB generating module 300 and the mk_FI generating module 201 instead of the delay module 205 (not shown) for receiving the reference signal FB and the target signal clock mask mk_FI and counting a cycle number Fb of the reference signal FB within the target signal clock mask mk_FI. From the perspective of the timing shown in FIG 1, the respective ways of counting the aforesaid two cycle numbers Fb bear the same degree of significance and thus yield exactly the same cycle numbers Fb.

A digital clock manager (hereinafter referred to as DCM for short) module 211 is connected to the FB generating module 300 for receiving the reference signal FB and generating M phase shift signals based on the reference signal FB. The M phase shift signals thus generated are of the same frequency and are spaced apart from each other by a fixed phase. This embodiment is exemplified by eight phase shift signals FB-p1~FB-p8.

An error counting module 209 is connected to the mk_FI generating module 201, the delay module 205, and the DCM module 211 for receiving the target signal clock mask mk_FI, the reference signal clock mask mk_FB, and the phase shift signals FB-p1~FB-p8, respectively, counting the number Nd1 of instances of occurrence of the third triggering state to the phase shift signals FB-p1~FB-p8 within the time period d_up that begins at the point in time t11 of commencement of the target signal clock mask mk_FI and ends at the point in time t21 of commencement of the reference signal clock mask mk_FB, and counting the number Nd2 of instances of occurrence of the third triggering state to the phase shift signals FB-p1~FB-p8 within the time period d_down that begins at the first ending point in time t12 of the target signal clock mask mk_FI and ends at the second ending point in time t22 of the reference signal clock mask mk_FB.

Referring to FIG 4, there is shown a function block diagram of the delay module 205 according to an embodiment of the present invention. The delay module 205 further comprises a first delay unit 205a and a second delay unit 205b. The first delay unit 205a is connected to the FB generating module 300 and the mk_FI generating module 201 for receiving the reference signal FB and the target signal clock mask mk_FI, and is adapted to generate the reference signal clock mask mk_FB. The second delay unit 205b is connected to the FB generating module 300 and the first delay unit 205a for receiving the reference signal FB and the reference signal clock mask mk_FB, setting a third beginning point in time t31 of the second triggering state synchronous with the reference signal FB based on the second beginning point in time t21, and setting a third ending point in time t32 of the second triggering state synchronous with the reference signal FB based on the second ending point in time t22, wherein the time period from t31 to t32 defines the time period of the delay clock mask mk_dly.

To reduce errors further, it is feasible to perform a high-precision measurement process on the generated reference signal FB beforehand. To preclude any error which might otherwise be produced because a frequency actually generated by the fundamental frequency generating unit 301 and the frequency multiplying unit 303 is different from a given frequency level (that is, a frequency level set forth in the specifications of the fundamental frequency generating unit 301 and the frequency multiplying unit 303), it is feasible to measure the reference signal FB generated by the FB generating module 300 by means of a high-precision frequency counter having a higher resolution than the frequency of the reference signal FB, and then use the measured reference signal FB as a default value to be directly stored in the control unit 400 or in a unit (such as a memory cell) operating in conjunction with the control unit 400. Alternatively, the frequency of the reference signal FB is retrogressively inferred by means of a precise frequency signal provided by a signal generating instrument, such that the inferred frequency of the reference signal FB is used as a default value to be directly stored in the control unit 400 or in a unit (such as a memory cell) operating in conjunction with the control unit 400. In doing so, in every instance of measurement, the default value always applies to the frequency of the reference signal FB, thereby dispensing with the need to use a parameter set forth in the specifications of the fundamental frequency generating unit 301 and the frequency multiplying unit 303.

In the embodiments of the present invention, the frequency counter comprises logical elements. The counting rule employed in the embodiments of the present invention reduces the complexity of arrangement of the logical elements, dispenses with a large-sized programmable gate array chip, and thus reduces the circuit-occupied area and downsizes the product. For example, if the computing function of the control unit 400 is also incorporated into the programmable gate array 200, the required number of the logical elements will be greatly increased, thereby increasing the circuit-occupied area. Due to its structural design, it is necessary for the programmable gate array 200 to perform computation by logic, and thus the computation is rapid; however, the required logical elements are bulky. Although a special programmable gate array having a computation structure circuit disposed therein has low logical element spatial requirements and can perform high-time computation, it incurs an excessively high cost.

In conclusion, with quick and precise multiphase processing, the frequency counter of the present invention eliminates frequency measurement errors which might otherwise arise from measurement of the target signal FI, and multiplies the accuracy of measurement in accordance with the quantity of generated phase shift signals. An embodiment of the present invention achieves eightfold reduction (corresponding to eight phase shift signals) in errors, effectuates the precise control of frequency measurement based on synchronous triggering, and reduces the area occupied by a circuit.

The present invention is disclosed above by preferred embodiments. However, persons skilled in the art should understand that the preferred embodiments are illustrative of the present invention only, but should not be interpreted as restrictive of the scope of the present invention. Hence, all equivalent modifications and replacements made to the aforesaid embodiments should fall within the scope of the present invention. Accordingly, the legal protection for the present invention should be defined by the appended claims.

**Claims**

1. A frequency counter for measuring a frequency of a target signal when enabled by a gate signal, comprising:

   a signal input end for receiving the target signal;
   a reference signal generating module for outputting a reference signal of a frequency Fb higher than the target signal;
   a programmable gate array for receiving a gate frequency to generate the gate signal, receiving the target signal from the signal input end to form a target signal clock mask, counting a cycle number Ni of the target signal within the target signal clock mask, receiving the reference signal from the reference signal generating module to form a reference signal clock mask, counting a cycle number Nb of the reference signal within the reference signal clock mask, generating M phase shift signals based on the reference signal, the phase shift signals being of a same frequency and spaced apart from each other by a fixed phase, wherein $M \geq 2$, counting a number Nd1 of instances of occurrence of a triggering state to the phase shift signals during a time period from a beginning point in time of the target signal clock mask to a beginning point in time of the reference signal clock mask, counting a number Nd2 of instances of occurrence of the same triggering state to the phase shift signals during a time period from an ending point in time of the target signal clock mask to an ending point in time of the reference signal clock mask, and outputting the values Nb, Ni, Nd1, and Nd2; and
   a control unit connected to the programmable gate array and the reference signal generating module for receiving the values Nb, Ni, Nd1, and Nd2 and performing computation based on $Fi = \{Ni/[Nb + (Nd/M)]\} \times Fb$ to obtain a frequency Fi of the target signal, wherein $Fb > Fi$, and $Nd = (Nd1 - Nd2)$.

2. The frequency counter of claim 1, wherein the programmable gate array comprises:

   a gate determining module for receiving the gate frequency and receiving the target signal from the signal input end to generate the gate signal;
   a clock mask generating module connected to the signal input end for receiving the target signal, wherein the clock mask generating module receives the gate signal from the gate determining module, sets a first beginning point in time of a first triggering state synchronous with the target signal based on the enabling gate signal, and sets a first ending point in time of the first triggering state synchronous with the target signal based on the disabling gate signal, so as to form the target signal clock mask;
   a target signal cycle number counting module connected to the signal input end and the clock mask generating module for receiving the target signal and the target signal clock mask so as to count a cycle number Fi of the target signal within the target signal clock mask;
   a delay module connected to the reference signal generating module and the clock mask generating module for receiving the reference signal and the target signal clock mask, wherein the delay module sets a second beginning point in time of a second triggering state synchronous with the reference signal based on the first beginning point in time and sets a second ending point in time of the second triggering state synchronous with the reference signal based on the first ending point in time so as to form the reference signal clock mask;

a reference signal cycle number counting module connected to the reference signal generating module and the delay module for receiving the reference signal and the reference signal clock mask and adapted to count a cycle number Fb of the reference signal within the reference signal clock mask;

a digital clock manager module connected to the reference signal generating module for receiving the reference signal and generating the phase shift signals based on the reference signal; and

an error counting module connected to the clock mask generating module, the delay module, and the digital clock manager module for receiving the target signal clock mask, the reference signal clock mask, and the phase shift signals, wherein the error counting module counts a number Nd1 of instances of occurrence of a third triggering state to the phase shift signals during a time period from a beginning point in time of the target signal clock mask to a beginning point in time of the reference signal clock mask and counts a number Nd2 of instances of occurrence of the third triggering state to the phase shift signals during a time period from an ending point in time of the target signal clock mask to an ending point in time of the reference signal clock mask.

3. The frequency counter of claim 2, wherein the delay module generates a delay clock mask based on the reference signal and adapted to delay the reference signal clock mask by a predetermined phase, thereby allowing the control unit to perform computation upon termination of the delay clock mask.

4. The frequency counter of claim 3, wherein the delay module comprises:

a first delay unit connected to the reference signal generating module and the clock mask generating module for receiving the reference signal and the target signal clock mask and generating the reference signal clock mask; and

a second delay unit connected to the reference signal generating module and the first delay unit for receiving the reference signal and the reference signal clock mask, wherein the second delay unit sets a third beginning point in time of the second triggering state synchronous with the reference signal based on the second beginning point in time and sets a third ending point in time of the second triggering state synchronous with the reference signal based on the second ending point in time, wherein the delay clock mask is defined between the third beginning point in time and the third ending point in time.

5. The frequency counter of claim 1, wherein the reference signal generating module comprises:

a fundamental frequency generating unit for generating a fundamental frequency signal; and

a frequency multiplying unit connected to the fundamental frequency generating unit for turning the fundamental frequency signal into the reference signal by frequency multiplication.

6. The frequency counter of claim 1, wherein the control unit replaces the value Fb with a default value.

7. The frequency counter of claim 2, wherein the first triggering state is one of a rising edge triggering state and a falling edge triggering state, the second triggering state is one of a rising edge triggering state and a falling edge triggering state, and the third triggering state is one of a rising edge triggering state and a falling edge triggering state.

8. The frequency counter of claim 2, wherein the reference signal cycle number counting module is connected to the reference signal generating module and the clock mask generating module for receiving the reference signal and the target signal clock mask and counting a cycle number Fb of the reference signal within the target signal clock mask.

9. The frequency counter of claim 1, wherein the programmable gate array sees the reference signal as the gate frequency.

FIG. 1

FIG. 2

FIG. 3

FIG. 4

Europäisches
Patentamt

European
Patent Office

Office européen
des brevets

# EUROPEAN SEARCH REPORT

Application Number

EP 11 18 2857

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | CN 102 116 797 A (TIANJIN 764 COMM AND NAVIGATION TECHNOLOGY CO LTD) 6 July 2011 (2011-07-06) * abstract; claims 1,2; figures 1-3 * * paragraphs [0003], [0009] - [0014] * | 1-9 | INV. G01R23/15 G01R23/10 |
| Y | US 2006/155512 A1 (ARIAV ARIE [IL] ET AL) 13 July 2006 (2006-07-13) * abstract; claims 1-3,5,7,21-23,25,27,28; figures 2,3 * * paragraphs [0043], [0048], [0053] - [0057], [0059] * | 1-9 | |
| L | JP 2011 232143 A (SEIKO EPSON CORP) 17 November 2011 (2011-11-17) * abstract; figures 8-10 * | 1-9 | |
| A | JP 1 062913 A (MATSUSHITA ELECTRIC IND CO LTD) 9 March 1989 (1989-03-09) * abstract; figures * | 1 | |
| A | WO 92/04634 A1 (SUNDSTRAND DATA CONTROL [US]) 19 March 1992 (1992-03-19) * abstract; figures 3-5 * | 1 | TECHNICAL FIELDS SEARCHED (IPC) G01R G01N H03L |
| A | EP 1 227 591 A1 (FUJITSU LTD [JP]) 31 July 2002 (2002-07-31) * abstract; figures 2-8 * | 1 | |

The present search report has been drawn up for all claims

| Place of search | Date of completion of the search | Examiner |
|---|---|---|
| Berlin | 5 November 2012 | Fritz, Stephan C. |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

                                                     
& : member of the same patent family, corresponding
   document

EPO FORM 1503 03.82 (P04C01)

**ANNEX TO THE EUROPEAN SEARCH REPORT
ON EUROPEAN PATENT APPLICATION NO.**

EP 11 18 2857

This annex lists the patent family members relating to the patent documents cited in the above-mentioned European search report.
The members are as contained in the European Patent Office EDP file on
The European Patent Office is in no way liable for these particulars which are merely given for the purpose of information.

05-11-2012

| Patent document cited in search report | | | Publication date | Patent family member(s) | | | Publication date |
|---|---|---|---|---|---|---|---|
| CN 102116797 | A | | 06-07-2011 | NONE | | | |
| US 2006155512 | A1 | | 13-07-2006 | IL | 166292 | A | 18-11-2009 |
| | | | | US | 2006155512 | A1 | 13-07-2006 |
| JP 2011232143 | A | | 17-11-2011 | NONE | | | |
| JP 1062913 | A | | 09-03-1989 | JP | 1062913 | A | 09-03-1989 |
| | | | | JP | 2563366 | B2 | 11-12-1996 |
| WO 9204634 | A1 | | 19-03-1992 | CA | 2091349 | A1 | 13-03-1992 |
| | | | | DE | 69123592 | D1 | 23-01-1997 |
| | | | | EP | 0548253 | A1 | 30-06-1993 |
| | | | | JP | 3591835 | B2 | 24-11-2004 |
| | | | | JP | H06501554 | A | 17-02-1994 |
| | | | | US | 5095264 | A | 10-03-1992 |
| | | | | WO | 9204634 | A1 | 19-03-1992 |
| EP 1227591 | A1 | | 31-07-2002 | CN | 1379929 | A | 13-11-2002 |
| | | | | DE | 60025732 | T2 | 20-07-2006 |
| | | | | EP | 1227591 | A1 | 31-07-2002 |
| | | | | JP | 3691310 | B2 | 07-09-2005 |
| | | | | JP | 2001119291 | A | 27-04-2001 |
| | | | | US | 6674277 | B1 | 06-01-2004 |
| | | | | US | 2004100245 | A1 | 27-05-2004 |
| | | | | WO | 0129969 | A1 | 26-04-2001 |

EPO FORM P0459

For more details about this annex : see Official Journal of the European Patent Office, No. 12/82